(19) Europäisches Patentamt

European Patent Office

Office européen des brevets

(11) **EP 0 766 353 B1**

(12) **EUROPEAN PATENT SPECIFICATION**

(45) Date of publication and mention
of the grant of the patent:
**08.09.1999 Bulletin 1999/36**

(51) Int Cl.6: **H01S 1/00**, H01S 1/06,
H03L 7/26, G04F 5/14

(21) Application number: **95115412.9**

(22) Date of filing: **29.09.1995**

(54) **Atomic frequency standard**

Atomfrequenznormal

Etalon de fréquence atomique

(84) Designated Contracting States:
**CH FR LI**

(43) Date of publication of application:
**02.04.1997 Bulletin 1997/14**

(60) Divisional application: **99100888.9 / 0 911 919**

(73) Proprietor: **OBSERVATOIRE CANTONAL DE NEUCHATEL**
**2000 Neuchâtel (CH)**

(72) Inventors:
• **Busca, Giovanni**
**CH-2000 Neuchâtel (CH)**
• **Bernier, Laurent-Guy**
**CH-2057 Villiers (CH)**
• **Rochat, Pascal**
**CH-2074 Marin (CH)**

(74) Representative: **Patry, Didier Marcel Pierre**
**I C B,**
**Ingénieurs Conseils en Brevets S.A.**
**Rue des Sors 7**
**2074 Marin (CH)**

(56) References cited:
GB-A- 2 044 521           US-A- 4 449 105
US-A- 4 706 042

• **IEEE TRANSACTIONS ON INSTRUMENTATION AND MEASUREMENT, vol. IM-36, no. 2, June 1987, NEW YORK US, pages 588-593, XP002005029 R.F.C.VESSOT ET AL.: "A HYDROGEN MASER AT TEMPERATURES BELOW 1 K"**

## Description

The present invention relates to atomic frequency standards, and more particularly to atomic frequency standards comprising a resonant cavity containing a medium capable of stimulated emission. The invention is suitable for use in active hydrogen masers and it will be convenient to hereinafter disclose the invention in relation to that exemplary application. It is to be appreciated, however, that the invention is not limited to this application. In particular, the invention is applicable to all active frequency standards, in which the stimulated emissions of the atomic medium is self-sustained, as well as to all passive frequency standards, which require external excitation.

An atomic hydrogen maser is a type of atomic frequency standard based on the hyperfine transition of atomic hydrogen at approximately 1.4 GHz. In such masers, a beam of atomic hydrogen is firstly supplied into a vacuum chamber. This atomic hydrogen traverses a state selecting magnet and enters a storage bulb in a microwave cavity. A state selector eliminates, by divergence, the hydrogen atoms situated in the lower state ($F=0$, $m_F=0$) and converges the hydrogen atoms situated in the upper energy state ($F=1$, $m_F=0$) towards the opening of the storage bulb. This storage bulb is situated at the centre of a cylindrical microwave cavity, tuned to the frequency of the hyperfine transition of the hydrogen atoms therein. For a passive maser, in order to observe the atomic resonance of the state selected hydrogen atoms, a microwave signal is injected into the resonant cavity at the resonance frequency of the hydrogen atoms. For an active maser, conditions are such that an output signal is available at the coupling loop. This signal is provided by the atomic oscillations.

Masers corresponding to this definition are known from the prior art. In order to ensure the frequency stability of such masers, a cavity resonant frequency control circuit is used to tune the resonant cavity to the natural frequency of the stimulated emission of the medium which it contains. For a passive maser, see for example US-A-4 449 105 or GB-A-2 044 521, a second control circuit, the injected interrogation signal control circuit, assures that the carrier frequency of the cavity interrogation signal is centred upon the natural frequency of the stimulated emissions. For an active maser, the atomic oscillation signal output has a frequency equal to the resonant frequency of the stimulated emissions.

In order to correctly tune the resonant cavity to the natural frequency of the stimulated emissions of the hydrogen atoms, some masers make use of using a tuning method known as the cavity frequency switching method. According to this method, a modulator switches the cavity resonant frequency between two values respectively greater and less than the natural frequency of the stimulated emission of the medium in the cavity, by applying a square wave voltage to a varactor tuning circuit coupled to the microwave cavity. The maser output level is then modulated when the average value of the cavity resonant frequency differs from the natural frequency of the stimulated emission of the medium in the cavity. After envelope detection at a microwave receiver output, and synchronous detection, an error signal is obtained. This error signal is then used to control the cavity resonant frequency.

The resonance curve of the cavity is thus interrogated at two frequencies, respectively greater and less than the natural frequency of the stimulated emission of the medium in the cavity, the line of the stimulated emission from the medium contained in the resonant cavity.

Whilst such masers have been found to be suitable in many applications, the inventors have found that this tuning method nevertheless introduces a spurious signal into the resonant cavity at a frequency close to that of the natural frequency of the stimulated emissions of the medium contained therein. As a consequence, amplitude and phase noise is introduced by the resonant cavity tuning circuit which perturbs the precision of the maser signal. Such errors are unacceptable in certain applications in which a time-reference signal of extremely high precision and stability is required.

An object of the present invention is to provide an atomic frequency standard which overcomes or alleviates the disadvantages of the prior art.

Another object of the invention is to provide an atomic frequency standard which has a high degree of precision.

A further object of the invention is to provide an atomic frequency standard of simple design and construction.

With that object in mind, the present invention provides an atomic frequency standard comprising a resonant cavity containing a medium capable of stimulated emission, means for injecting into said cavity a signal with a frequency centred on the natural frequency of said stimulated emission, means for effecting a shift in the frequency of said injected signal so as to generate alternately a first signal portion having a frequency greater than the natural frequency of said stimulated emission and a second signal portion having a frequency less than the natural frequency of said stimulated emission, said first and second signal portions having a periodicity corresponding to a predetermined interrogation period, means responsive to a signal detected in said cavity to produce an error signal representing the difference between the amplitude of said detected signal in response to the injection of said first signal portion and the amplitude of said detected signal in response to the injection of said second signal portion, and means responsive to said error signal for adjusting the resonant frequency of said cavity, characterised in that said atomic maser further comprises means for periodically applying each of said first and second signal portions for a limited duration only of said interrogation period.

The invention makes it possible to provide an atomic frequency standard having a degree of precision which is markedly better than in known frequency standards.

Advantageously, such a frequency standard may be achieved without the need to reduce the instantaneous power of the injected signals for tuning the cavity resonant frequency. Interrogation of the resonance curve of the cavity may therefore be performed without using extremely sensitive and complex detection circuitry.

The following description refers in more detail to the principles and various features of the atomic frequency standard of the present invention. In order to facilitate an understanding of the invention, reference is made in the description to the accompanying drawings where the invention is illustrated in a preferred embodiment. It is to be understood that the atomic frequency standard of the present invention is not limited to the preferred embodiment as illustrated in the drawings.

In the drawings:

Figure 1 is a schematic diagram showing the principles of operation of an atomic frequency standard embodying the invention;
Figure 2 is a schematic diagram of one embodiment of the control circuitry of an atomic frequency standard of figure 1;
Figure 3 shows the resonance curve of the cavity of the atomic frequency standard of figure 2; and,
Figure 4 shows a cross-sectional view of one example of the storage bulb and microwave cavity suitable for use in the atomic frequency standard of figure 1.

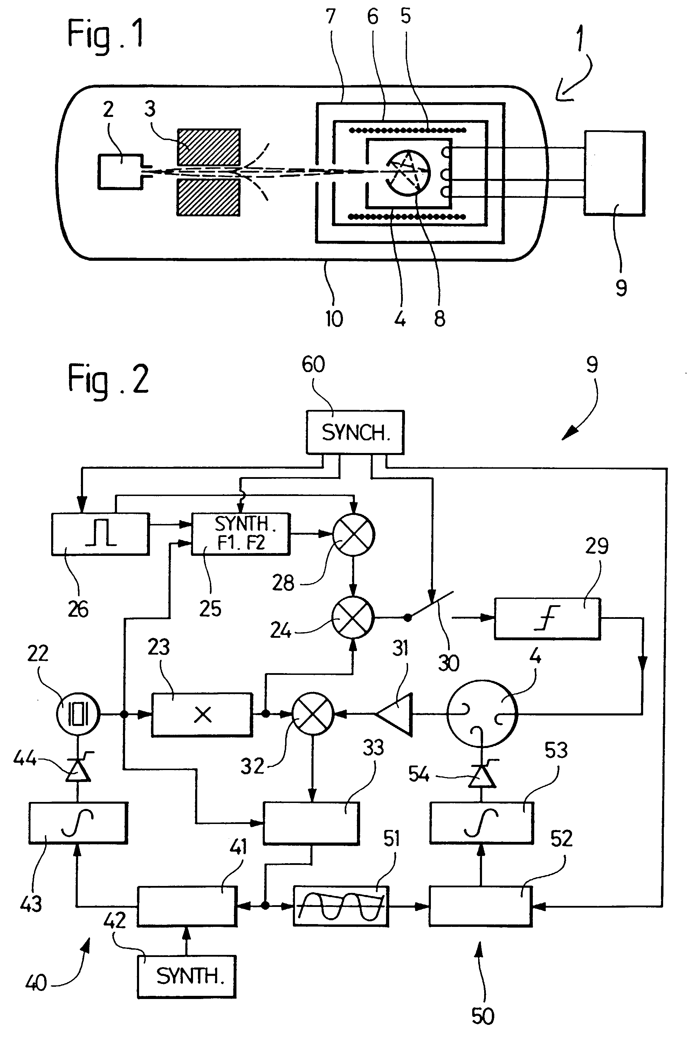

The operating principles of one example of an atomic maser according to the present invention will now be described with reference to figure 1. In particular, figure 1 shows an atomic hydrogen maser 1 comprising a source 2 of a medium capable of stimulated emission, a state selector 3, a resonant cavity 4, a coil 5, two magnetic shields 6 and 7, a storage bulb 8 and associated control circuitry 9. The elements 2 to 7 of the atomic hydrogen maser 1 are mounted in a vacuum chamber 10.

The beam source 2 is a radio-frequency gas discharge in molecular hydrogen which produces atomic hydrogen with high efficiency. The atomic hydrogen beam leaves the source 2 through one or many channels into the vacuum chamber 10. The beam of atomic hydrogen traverses a state selecting magnet 3 and enters the storage bulb 8 in the microwave cavity 4. The state selector 3 eliminates, by divergence, the hydrogen atoms situated in the lower state (F=0, $m_F$=0) and converges the hydrogen atoms situated in the upper energy state (F=1, $m_F$=0) towards the opening of the storage bulb 8. This storage bulb 8 is situated at the centre of a cylindrical microwave cavity, tuned to the frequency of the hyperfine transition of the hydrogen atoms therein.

A connection is also effected between the control circuitry 9 and the resonant cavity 4 in order that this latter may be tuned to the natural frequency of the stimulated emissions of the hydrogen atoms in the storage bulb.

In a maser of this type, the transition frequency of the hydrogen atoms depends upon the magnetic field in the resonant cavity 4. In order to obtain an output signal having a constant predetermined frequency, the transitions of the atomic hydrogen must take place in a constant magnetic field. In order to obtain this constant magnetic field, it is necessary to shield the zone of interaction between the exterior magnetic field by means of the two magnetic shields 6 and 7 so that the value of the residual field is insignificant. The constant magnetic field is produced by the coil 5 surrounding the cavity 4 and situated inside the magnetic shields 6 and 7.

Referring now to figure 2, there is the cavity 4 and the control circuitry 9 of the maser of figure 1. An oscillator circuit 22 produces a signal at a frequency of 100 MHz. This signal is applied to a frequency multiplier 23 which provides at its output a signal at a frequency of 1400 MHz.

The control circuitry 9 also includes a switchable synthesiser 25 and a pulse generator 26. The switchable synthesiser 25 selectively provides an output signal having either a frequency $f_1$ or a frequency $f_2$ such that the average of these two frequencies corresponds to the natural frequency of the stimulated emissions of the medium in the storage bulb 8. Typical values of these two frequencies in the case of an atomic hydrogen maser may be, for example, 20.420 MHz and 20.390 MHz.

The pulse generator 26 generates two series of pulses and the operation thereof will be explained in detail further below.

The outputs of the switchable synthesiser 25 and the pulse generator 26 are both applied to the inputs of a mixer 28 so that the signal generated by the switchable synthesiser 25 is modulated by the pulses from the pulse generator 26.

The outputs of the frequency multiplier 23 and the mixer 28 are applied to a mixer 24 which provides a signal whose average value is close to 1420 MHz, which is firstly amplitude limited by an attenuator circuit 29 and then introduced into the resonant cavity 4. The attenuator circuit 29 acts to limit the power of the signal injected into the resonant cavity 4.

A switch may be connected between the output of the mixer 24 and the input of the attenuator 29 for better rejection of the interrogation signal during dead times.

The resonant cavity 4 is tuned to the natural frequency $f_R$ of the stimulated emission of the medium which it contains. In the case of a hydrogen maser, the transition which gives rise to the stimulated emission is the transition from the state F=1, $m_F$=0 to the state F=0, $m_F$=0 of a hydrogen atom which is placed in a magnetic field for separating the Zeeman sub-levels $m_F$=+1 and $m_F$=-1 from the state F=0. The natural frequency $f_R$ of

this transition is in the region of 1420 MHz (1420.405751...MHz).

The cavity 4 can be considered as a band-pass filter whose quality factor $Q_c$ varies between 30000 and 60000, depending upon the volume of the cavity. For a quality factor of the order of 30000, the cavity with the medium which it contains can be considered as a combination of such a filter with filter having a quality factor $Q_H$ of the order of $10^9$.

An amplifier 31 receives and amplifies the maser signal. The carrier frequency of this signal firstly combined, by a mixer 32, with the signal from the output of the frequency multiplier 23 and is then down-converted by a frequency changer circuit 33 to an intermediate-frequency $f_i$. The output signal of the frequency changer circuit 33 is applied, firstly, to an oscillator control circuit 40 and, secondly, to a cavity control circuit 50.

In the control means 40 of the oscillator circuit 22, the signal supplied by the frequency changer circuit 33 is applied to a phase comparator 41 which produces an error signal corresponding to the phase difference between the output of a synthesiser 42 and the intermediate frequency from the frequency changer circuit 33.

Any phase shift results in an error signal at the output of the phase detector 41. The error signal is applied to an integrator 43 and used for controlling a variable capacitor 44 which is coupled to the oscillator circuit 22, whereby its frequency may be slightly varied for correction thereof.

In the control means 50 of the cavity 4, the output signal of the frequency changer circuit 33 is applied to an envelope detector 51. The output of this latter is received by a synchronous detector 52 which extracts the microwave signal impressed on the intermediate-frequency $f_i$ resulting from the injection into the cavity of the pulsed signal from the output of the mixer 24.

More precisely, the synchronous detector 52 measures and compares the amplitude of the detected cavity signal resulting from the injection of the signal pulses, which have been generated from a combination of the output signals of the switchable synthesiser 25 and the pulse generator 26 and which have a frequency $f_1$, with that of the detected cavity signal resulting from the injection of the signal.pulses having a frequency $f_2$.

An error signal is produced from this comparison which indicates a shift in the resonance frequency of the cavity 4 with respect to the natural frequency of the stimulated emissions. The error signal is applied to an integrator 53 whose output is connected to a variable capacitor 54 which is in turn coupled to the cavity 4, whereby the resonance frequency $f_C$ of this latter may be slightly varied for correction purposes.

The control circuitry 9 further comprises a synchronisation module 60 which synchronises notably the operation of the synchronous detection circuit 52 with that of the pulse generator 26 and the switchable synthesiser 25. In addition, the synchronisation module 60 acts upon the control switch 30 so as to reject any residual signal from the mixer 24.

The basic equation for the above-described phenomenon of cavity pulling is set out in "The Quantum Physics of Atomic Frequency Standards" by Vanier and Audoin (Adam Nilger, 1989, page 1039). According to this publication, the maser frequency pulling $\frac{\Delta f_m}{f}$ caused by the interrogation of the resonant cavity is giv-en by :

$$\frac{\Delta f_m}{f_m} = \frac{f_m}{8 Q_l (f_{int} - f_m)} \times \frac{P_{cav}}{P_{at}}$$

where $f_{int}$ is the frequency of the cavity interrogation signal, $P_{cav}$ is the power inside the cavity for a given incident or interrogation power detuned by one half-bandwidth, $P_{at}$ is the atomic power inside the cavity for a given maser output power, $Q_l$ is the quality factor of the resonant cavity and $f_m$ is the maser frequency.

However, if the interrogation signal which is applied to the resonant cavity is pulsed so as to interrogate only periodically the resonant cavity, for example, in the manner described above in relation to the pulse generator 26 and the switchable synthesiser 25 of figure 2, this equation becomes :

$$\frac{\Delta f_m}{f_m} = \frac{f_m}{8 Q_l (f_{int} - f_m)} \times \frac{P_{cav}}{P_{at}} \times 2 \frac{\tau_{ON}}{\tau}$$

where $\tau_{ON}$ is the time duration of the each of the interrogation pulses each interrogation period and $\tau$ is the time duration of that interrogation period.

From this, it can be seen that pulling of the maser frequency is a linear function of $\tau_{ON}$. It can also be seen that the pulling of the maser frequency is also directly proportional to the interrogation power applied to the resonant cavity. By appropriate setting of the duration of the interrogation pulses with respect to their periodicity, it is therefore possible to minimise the error in the maser frequency caused by the interrogation of the cavity frequency, whilst nevertheless maintaining the power of the interrogation signal at a sufficiently high level to facilitate the detection of the cavity response thereto.

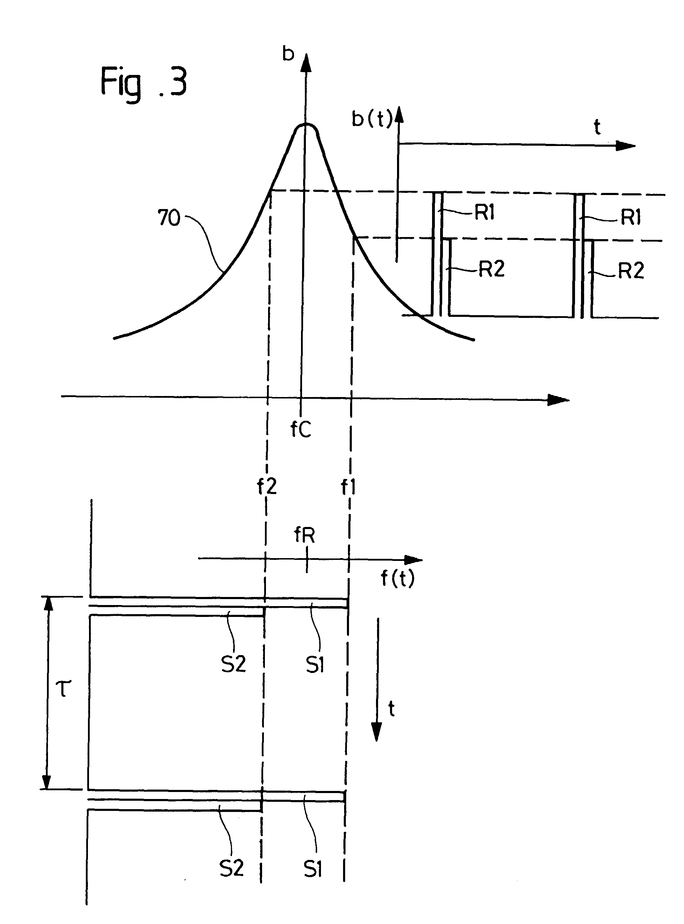

The foregoing will be more clearly understood by referring to figure 3, which shows the resonance curve 70 of the cavity 4 of the maser 1 of figure 1. This curve 70 is symmetric about a peak value at its reso-nance frequency $f_C$.

During operation of the control circuit 9 of the maser 1, the pulse generator 26 is controlled by the synchroniser 60 so that it generates two series of pulses, respectively referenced S1 and S2. Each of these series of pulses S1 and S2 has a periodicity $\tau$ and a predeter-mined duration $\tau_{ON}$ which is substantially less than the period or interrogation period $\tau$. The synchroniser 60 al-so synchronises the operation of the switchable synthesiser 25 and the pulse generator 26 so that the series of pulses S1 have a frequency $f_1$ whilst the second series of pulses S2 have a frequency $f_2$. The switchable synthesiser 25 is adapted so that the two frequencies $f_1$ and $f_2$ are centred on, and are therefore symmetrical about, the natural frequency $f_R$ of the stimulated emissions of the medium stored in the storage bulb 8.

The response of the resonant cavity 4 to each of the series of pulses S1 and S2 is respectively referenced R1 and R2. As can be seen, the amplitude b(t) of the cavity response, and hence the amplitude of the signal detected by the synchronous detection circuit 52 in response to the series of pulses S1 and S2, depends respectively upon the value of the frequencies $f_1$ and $f_2$. If the average of these two frequencies corresponds to the resonant frequency $f_C$ of the cavity 4, this latter will be tuned to the natural frequency of the stimulated emissions of the medium stored in the storage bulb 8 and the amplitude of the responses R1 and R2 will be identical. Accordingly, the value of the error signal generated at the output of the synchronous detection circuit 52 will be zero.

If, however, the average of these two frequencies differs from the frequency at which the cavity 4 resonates, as shown in figure 3, the amplitude of the responses R1 and R2 will be different. This difference indicates that the resonant frequency $f_C$ of the cavity 4 is not tuned to the natural frequency $f_R$ of the stimulated emissions of the medium stored in the storage bulb 8. In response to the comparison of the amplitudes of R1 and R2 effectuated by the synchronous detection circuit 52, the value of the error signal generated at the output thereof will be non-zero. This error signal will be integrated by the integrator circuit 53 and applied to the variable capacitor 54 so as to correct the resonant frequency of the cavity 4.

As will be understood from figure 3, the present invention concentrates the power of the cavity interrogation signal into two signal portions, in this case the pulses S1 and S2, which are each applied for a limited duration only of each interrogation period τ. Accordingly, a high precision maser is obtained whilst nevertheless maintaining the instantaneous power of the interrogation signal injected into the resonant cavity at a level sufficient to ensure the correct operation of the cavity control circuit 50.

Whilst the pulses in the series S1 and S2 are shown in figure 3 as being contiguous, it is preferable in practice that they be separated by at least a minimum settling time. This latter should be sufficient to enable the signal resulting from the response R1 and detected by the synchronous detection circuit 52 to have settled prior to the detection of the signal resulting from the response R2.

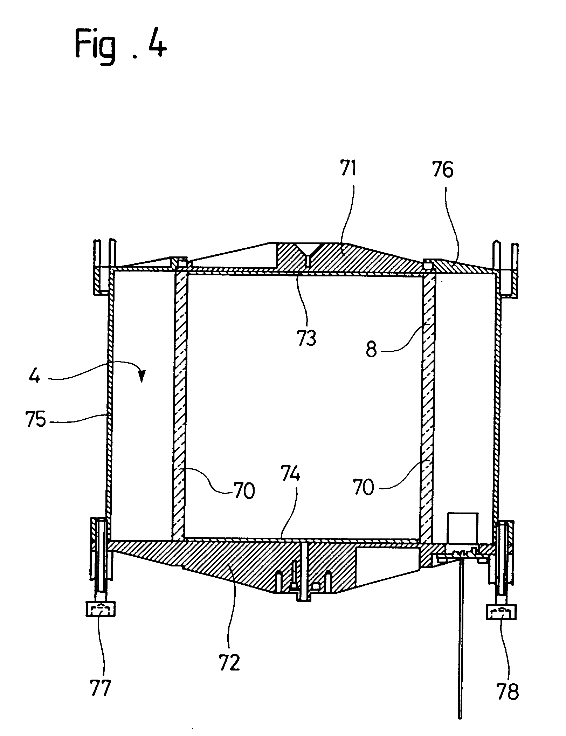

Figure 4 shows an example of the storage bulb 4 and microwave cavity 8 suitable for use with the control circuitry 9 shown in figures 2 and 3.

Atomic hydrogen masers known from the prior art generally include a storage bulb which is either supported or mounted at the centre of a cylindrical resonant cavity by means of rods, so as to maximise the magnetic field concentration in the vicinity of the medium in the storage bulb. These rods extend from the walls of the resonant cavity to the storage bulb. The storage bulb and the mounting rods are made from quartz which has low electric losses and thus does not significantly spoil the quality factor of the resonant cavity.

In addition, a coating of polyfluoroethene is applied to the inner surface of the storage bulb. This coating allows many collisions of the hydrogen atoms or other medium stored in the storage bulb with the walls of this latter without significantly disturbing the oscillations of the atoms. In order to further minimise the electrical losses of the microwave cavity, the inner walls of the cavity are coated with a lining of metal, such as silver or aluminium.

Another known type of maser includes a storage bulb made of sapphire and mounted centrally within an aluminium resonant cavity. The storage bulb comprises a monocrystaline sapphire cylinder which is closed at both ends by sapphire closure members. In this type of maser, the storage bulb is made from sapphire as this material has an extremely high dielectric constant which results in even lower electric losses than it possible with quartz.

Each of the closure members consists of a plate for closing one of the two cylinder openings, each plate having a number of projections on the surface which is external to the cylinder. These projections are integral with the plate and extend laterally from the plate and away from the sapphire cylinder so as support the storage bulb in the centre and away from the walls of the cavity when the maser is assembled. The sapphire cylinder and the sapphire closure members are maintained in fixed relation, firstly, by compression applied from the walls of the resonant cavity when the maser is assembled and, secondly, by means of sapphire-sapphire bonding between contiguous parts of the cylinder and the closure members. A storage bulb of uniform composition and structure is thus obtained which, when centrally mounted in the resonant cavity, has extremely low electric losses.

However, these known masers have all a relatively large volume, which is undesirable in many situations, notably in masers intended to be included in satellites or other applications in space.

In addition, such masers suffer from the problem of mechanical instability. In particular, only a few support rods or projections between the storage bulb and the walls of the resonant cavity can be used in each maser, in order that the disturbance to the quality factor of the cavity is kept to a minimum. However, this results in a certain structural fragility which is undesirable in applications involving mechanical shocks, such as are encountered in spaceborne masers.

The maser shown in figure 4 overcomes these problems by providing a walled enclosure defining a resonant cavity 4 therein and a storage bulb 8 for storing a medium capable of stimulated emission, the storage bulb comprising a sapphire cylinder, open at both ends, and two closure members for closing said cylinder ends, wherein the closure members are made substantially of titanium and have a coating of polyfluoroethene formed on their inner surfaces and at least one of said closure members form part of said walled enclosure.

Due to this combination of characteristics, a maser is provided which is both structural rigid and which optimises the size of the resonant cavity and the storage bulb.

The storage bulb 8 shown in figure 4 comprises a sapphire cylinder 70, made preferably from monocrystaline sapphire. The sapphire cylinder 70 has an opening at both end of its longitudinal axis. These openings are closed by two closure members, respectively referenced 71 and 72.

The closure members 71 and 72 are made at least substantially of titanium, which is a light yet extremely rigid material and is therefore well suited to applications where these qualities are important, such as in spaceborne masers.

In addition, the closure members 71 and 72 each have a coating, respectively referenced 73 and 74, of polyfluoroethene formed on their inner surfaces so as to allow many collisions of the hydrogen atoms stored in the storage bulb 8 with the walls of this latter without significantly disturbing the oscillations of the atoms. A similar coating of also formed on the inner surface of the sapphire cylinder 70 for the same reasons.

As seen from figure 4, the resonant cavity 4 is defined by a walled enclosure 76 which is partially formed by the two closure members 71 and 72. More particularly, the walled enclosure 76 comprises a cylindrical shell 75, which is closed at both ends by end walls, and the two closure members 71 and 72. In this embodiment, the closure members 71 constitutes part of one end wall of the walled enclosure 76 whilst the closure member 72 entirely constitutes the other end wall of the walled enclosure 76.

This structure enables a significant reduction in the size and an improvement in the structural strength of the resonant cavity when compared to the prior art, as the storage bulb is no longer centrally supported within the resonant cavity so as to be separate from the walled enclosure but now actually forms part of the walled enclosure defining the cavity.

It is known that the magnetic field generated in the resonant cavity is zero at the walls which define it and has a maximum at the centre of the cavity. The prejudice in the field of maser construction has therefore been to avoid at all costs the placement of the storage bulb near the walls which define the resonant cavity so as to avoid amplitude modulation of the magnetic field experienced by the hydrogen atoms in the storage bulb. It was believed that any such modulation would have an adverse effect on the microwave signal detected in the resonant cavity.

Furthermore, a prejudice in the field of maser construction has been to construct storage bulbs entirely from one material, such as quartz or sapphire. It was believed that the use of a homogenous material was necessary to avoid any disorientation of the hydrogen atoms in the storage bulb, and that such disorientation would cause the hydrogen atoms to lose their phase, once again creating an adverse effect on the microwave signal detected in the resonant cavity.

Surprisingly, the inventors have found that the line of the stimulated emission from the medium contained in the resonant cavity not adversely affected by the structure shown in figure 4 wherein the storage bulb closure members form part of the walled enclosure defining the cavity. Equally unexpected was the fact that the inventors determined that a coating of polyfluoroethene on the inner surface of the closure members acts to mask the nature of the material forming these members from the hydrogen atoms in the storage bulb, and that the sapphire cylinder itself substantially determines the dielectric characteristics of the storage bulb. Accordingly, the structural and spatial advantages described above are obtained by the structure shown in figure 4, without suffering a degradation in the quality of the maser signal.

Preferably, the closure members 71 and 72 are fixed to the sapphire cylinder 70 by means of one or more aluminium diffusion bonds. Such bonds have been previously developed for joining optically transparent materials to metal housings to allow the bonding of two dissimilar materials, one of which is brittle. Such bonds are formed by the thermal diffusion of aluminium into the surface layers of the two dissimilar materials. Next, the two materials are pressed together at elevated temperatures in a vacuum. Aluminium diffusion bonding of sapphire to titanium is especially suited to the present invention because of the very similar thermal expansion coefficients of the two materials.

The cylindrical shell is preferably substantially made of titanium in order that the walled enclosure 76 is composed of elements (i.e. the cylindrical shell 75 and the closure members 71 and 72) which are homogeneous and which have the same electromagnetic properties.

As seen in figure 4, the structural strength of the storage bulb 8 and the walled enclosure 75 is reinforced by the fact that the closure member 72 extends beyond the sapphire cylinder 70 so as to entirely constitute one of the end walls of the walled enclosure 76. Such an arrangement adds, firstly, to the simplicity of the maser by limiting the numbers of elements required to construct the resonant cavity and the storage bulb and, secondly, to the mechanical strength of the maser by limiting the number of joins which need to be made between the various elements constituting the resonant cavity and the storage bulb.

The cylindrical shell 75 may be releasably mounted to one of the closure members, as is the case of the closure member 72 in figure 4, which closure member extends beyond the sapphire cylinder 70. In this example, titanium bolts 77 and 78 are used to secure these two elements together.

Whilst in the resonant cavity shown in figure 4 both closure members 71 and 71 form at least part of the end wall of the walled enclosure 76, it will be appreciated that only one closure member need constitute part of one such end wall in order for a reduction in the dimensions of the maser to be achieved.

## Claims

1. Atomic maser comprising

   - a resonant cavity (4) containing a medium capable of stimulated emission,
   - means (22,23,24,29) for injecting into said cavity (4) a signal with a frequency $(f_1, f_2)$ centred on the natural frequency $(f_R)$ of said stimulated emission,
   - means (25) for effecting a shift in the frequency of said injected signal so as to generate alternately a first signal portion having a frequency $(f_1)$ greater than the natural frequency $(f_R)$ of said stimulated emission and a second signal portion having a frequency $(f_2)$ less than the natural frequency $(f_R)$ of said stimulated emission, said first and second signal portions each having a periodicity $(\tau)$ corresponding to a predetermined interrogation period,
   - means (31,32,33,51,52) responsive to a signal detected in said cavity (4) to produce an error signal representing the difference between the amplitude of said detected signal (R1) in response to the injection of said first signal portion and the amplitude of said detected signal (R2) in response to the injection of said second signal portion, and
   - means (53,54) responsive to said error signal for adjusting the resonant frequency $(f_C)$ of said cavity,

   characterised in that
   said atomic maser further comprises

   - means (26,28) for periodically applying each of said first and second signal portions for a limited duration only $(\tau_{ON})$ of said interrogation period.

2. Atomic maser according to claim 1, characterised in that said means (26,28) for periodically applying each of said first and second signal portions comprise

   - pulse generating means (26) for generating a first and a second series of pulses (S1,S2) such that each of said series of pulses has a periodicity $(\tau)$ corresponding to said interrogation period and such that each of said pulses has a predetermined duration $(\tau_{ON})$ substantially less than said interrogation period, and
   - means (28) for modulating said pulses with said injected signal.

3. Atomic maser according to claim 2, characterised in that it further comprises

   - means (60) for synchronising said frequency shifting means (25) and said pulse generating means (26) so as to generate a series of pulses (S1) of said first signal portion and a series of pulses (S2) of said second signal portion.

4. Atomic maser according any one of the preceding claims, characterised in that
   said means (25) for effecting a shift in the frequency of said injected signal comprise a programmable frequency synthesiser.

5. Atomic maser according to any one of the preceding claims, characterised in that
   said means (26,28) for periodically applying both said first and second signal portions are adapted to separate said first and second signal portions by at least a minimum settling time.

## Patentansprüche

1. Atom-Maser, mit

   - einem Resonanzraum (4), der ein zu einer stimulierten Emission fähiges Medium enthält,
   - einer Einrichtung (22, 23, 24, 29) zum Einleiten eines Signals mit einer Frequenz $(f_1, f_2)$, die auf die Eigenfrequenz $(f_R)$ der stimulierten Emission zentriert ist, in den Raum (4),
   - einer Einrichtung (25) zum Ausführen einer Verschiebung der Frequenz des eingeleiteten Signals, um so abwechselnd einen ersten Signalabschnitt mit einer Frequenz $(f_1)$, die größer als die Eigenfrequenz $(f_R)$ der stimulierten Emission ist, und einen zweiten Signalabschnitt mit einer Frequenz $(f_2)$, die kleiner als die Eigenfrequenz $(f_R)$ der stimulierten Emission ist, zu erzeugen, wobei der erste und der zweite Signalabschnitt jeweils eine einer vorgegebenen Abfrageperiode entsprechende Periodizität $(\tau)$ besitzen,
   - einer Einrichtung (31, 32, 33, 51, 52), die als Antwort auf ein in dem Raum (4) erfaßtes Signal ein Fehlersignal erzeugt, das die Differenz zwischen der Amplitude des erfaßten Signals (R1), das durch die Einleitung des ersten Signalabschnitts bedingt ist, und der Amplitude des erfaßten Signals (R2), das durch die Einleitung des zweiten Signalabschnitts bedingt ist, darstellt, und

- einer Einrichtung (53, 54), die als Antwort auf das Fehlersignal die Resonanzfrequenz ($f_C$) des Raums einstellt,

dadurch gekennzeichnet, daß
der Atom-Maser ferner enthält:

- Einrichtungen (26, 28) zum periodischen Anlegen jedes der ersten und zweiten Signalabschnitte lediglich für eine begrenzte Dauer ($\tau_{ON}$) der Abfrageperiode.

2. Atom-Maser nach Anspruch 1, dadurch gekennzeichnet, daß die Einrichtungen (26, 28) zum periodischen Anlegen jedes der ersten und zweiten Signalabschnitte enthalten:

- eine Impulserzeugungseinrichtung (26) zum Erzeugen einer ersten und einer zweiten Reihe von Impulsen (S1, S2), derart, daß jede der Reihen von Impulsen eine der Abfrageperiode entsprechende Periodizität ($\tau$) besitzt und daß jeder der Impulse eine vorgegebene Dauer ($\tau_{ON}$) besitzt, die wesentlich kleiner als die Abfrageperiode ist, und

- eine Einrichtung (28) zum Modulieren der Impulse mit dem eingeleiteten Signal.

3. Atom-Maser nach Anspruch 2, dadurch gekennzeichnet, daß er ferner enthält:

- eine Einrichtung (60) zum Synchronisieren der Frequenzverschiebungseinrichtung (25) und der Impulserzeugungseinrichtung (26), um eine Reihe von Impulsen (S1) des ersten Signalabschnitts und eine Reihe von Impulsen (S2) des zweiten Signalabschnitts zu erzeugen.

4. Atom-Maser nach irgendeinem der vorangehenden Ansprüche, dadurch gekennzeichnet, daß die Einrichtung (25) zum Ausführen einer Verschiebung der Frequenz des eingeleiteten Signals einen programmierbaren Frequenzsynthetisierer enthält.

5. Atom-Maser nach irgendeinem der vorangehenden Ansprüche, dadurch gekennzeichnet, daß die Einrichtungen (26, 28) zum periodischen Anlegen sowohl der ersten als auch der zweiten Signalabschnitte so beschaffen sind, daß sie den ersten und den zweiten Signalabschnitt wenigstens um eine minimale Ausregelzeit trennen.

## Revendications

1. Maser atomique comprenant

- une cavité résonante (4) contenant un milieu pouvant entretenir une émission stimulée,
- des moyens (22, 23, 24, 29) pour injecter dans cette cavité (4) un signal avec une fréquence ($f_1$, $f_2$) centrée sur la fréquence naturelle ($f_R$) de cette émission stimulée,
- des moyens (25) pour effectuer un décalage en fréquence du signal injecté de manière à engendrer alternativement une première partie de signal ayant une fréquence ($f_1$) plus grande que la fréquence nature ($f_R$) de ladite émission stimulée et une seconde partie de signal ayant une fréquence ($f_2$) plus petite que la fréquence naturelle ($f_R$) de ladite émission stimulée, lesdites première et deuxième parties de signal ayant chacune une périodicité ($\tau$) correspondant à une période d'interrogation prédéterminée,
- des moyens (31, 32, 33, 51, 52) répondant à un signal détecté dans ladite cavité (4) pour produire un signal d'erreur représentatif de la différence entre l'amplitude dudit signal détecté (R1) en réponse à l'injection de ladite première partie de signal et l'amplitude dudit signal détecté (R2) en réponse à l'injection de ladite deuxième partie de signal, et
- des moyens (53, 54) répondant audit signal d'erreur pour ajuster la fréquence résonante ($f_C$) de ladite cavité,

caractérisé en ce que
ledit maser atomique comprend en outre

- des moyens (26, 28) pour appliquer périodiquement chacune desdites première et deuxième parties de signal pour seulement une durée limitée ($\tau_{ON}$) de ladite période d'interrogation.

2. Maser atomique selon la revendication 1, caractérisé en ce que lesdits moyens (26, 28) pour appliquer périodiquement chacune desdites première et deuxième parties de signal comprennent

- des moyens de génération d'impulsions (26) pour générer une première et une deuxième série d'impulsions (S1, S2) de manière que chacune de ces séries d'impulsions a une périodicité ($\tau$) correspondant à la période d'interrogation et de manière que chacune de ces impulsions a une durée prédéterminée ($\tau_{ON}$) essentiellement moindre que ladite période d'interrogation, et

- des moyens (28) pour moduler lesdites impulsions avec ledit signal injecté.

3. Maser atomique selon la revendication 2, caractérisé en ce qu'il comprend en outre

    - des moyens (60) pour synchroniser lesdits moyens de décalage en fréquence (25) et lesdits moyens de génération d'impulsions (26) de manière à générer une série d'impulsions (S1) de ladite première partie de signal et une série d'impulsions (S2) de ladite deuxième partie de signal.

4. Maser atomique selon l'une quelconque des revendications précédentes, caractérisé en ce que lesdits moyens (25) pour effectuer un décalage en fréquence du signal injecté comprennent un synthétiseur de fréquence programmable.

5. Maser atomique selon l'une quelconque des revendications précédentes, caractérisé en ce que lesdits moyens (26, 28) pour appliquer périodiquement les deux première et deuxième parties de signal sont agencées pour séparer ces première et deuxième parties de signal par au moins un temps minimum de stabilisation.

EP 0 766 353 B1

Fig.1

Fig.2

10

Fig .3

# Fig . 4